# EUROPEAN PATENT APPLICATION

(11) **EP 0 866 337 A2**
(43) Date of publication of application: **23.09.1998**
(21) Application number: 97118885.9
(22) Date of filing: 30.10.1997
(51) Int. Cl.: G01R 1/067, G01R 31/28

(54) **Rigid needle for the electrical test on printed circuit boards**

(30) Priority: 19.03.1997 IT MI970629
(71) Applicant: CIRCUIT LINE S.P.A., I-37139 Verona (IT)
(72) Inventor: Giani, Alberto, 37124 Verona (IT)
(74) Representative: Petruzziello, Aldo

(57) **Abstract**

A rigid needle is described for the electrical test on printed circuit boards, particularly for the test on metallized holes (90) in the printed circuit board, having a permanent deformation or bend (70) in an intermediate area thereof, able to rest on an intermediate plate (40) of the interface (10) of the test machine in which said needle (1) is inserted, the size of the arrow ("f") of said bend (70) being greater than the diameter of the hole (41) in the plate (40) through which the needle (1) is inserted, and smaller than the radius of the point or head (60) of the needle.

## Description

The present invention relates to a rigid needle for the electrical test on printed circuit boards, in particular for the test on metallized holes in printed circuit boards.

On the market for products for the electrical test on printed circuit boards without components, there are test needles consisting of a small bar of music wire that has a point at one end made of conductive material (for example brass or copper alloys) serving to increase the diameter of the needle to allow testing of metallized holes in the printed circuit board. The point must make contact with the circumference of the metallized hole without the needle being able to enter into the hole. The diameter of the point must therefore be greater than the diameter of the hole. Points of various diameters are available to suit the varying diameter of the hole, whereas the diameter of the stem usually remains unchanged.

This type of test needle cannot be used in particular on the upper fixtures of test machines, that is, on fixtures suitable for electrically connecting the test points of the upper side of the printed circuit board to the upper measuring point grid of the test machine, in that this test needle is not provided with devices to allow it to be retained inside the adapter interface. The same problem arises, though to a lesser extent, for the lower fixtures of test machines, that is, fixtures suitable for electrically connecting the test points of the underside of the printed circuit board to the lower measuring point grid of the test machine.

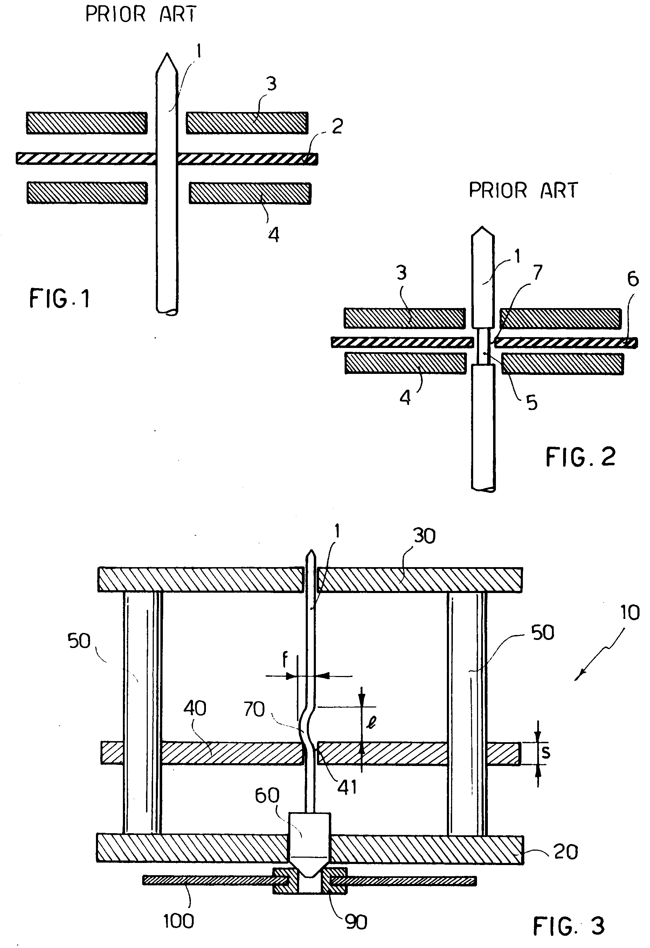

Some types of equipment proposed hold the needle in position through the friction forces that are generated by passing (stabbing) the needle 1 through a thin layer 2 of rubbery (latex) or spongy material, interposed between two plates 3, 4 of the corresponding interface of the test machine (Figure 1).

Another known solution consists in using needles 1 provided with a reduction in diameter or groove 5 in the stem. A thin sheet of Mylar 6 having a hole 7 where the needle passes, engages in the groove 5. The diameter of the hole 7 in the Mylar sheet is slightly smaller than the diameter of the stem of the needle but greater than the diameter of the groove 5 made in the stem. Elastic yielding of the Mylar sheet allows insertion of the needle, whereas retention is achieved by the hole 7 returning to the initial size (Figure 2).

A disadvantage of retention methods relying on friction force (Figure 1) or mechanical interference (Figure 2) is that they require supporting sheets for the needles to be added in the interface structure, as well as further intermediate plates to contain the supporting sheets. It is therefore necessary for interface components having the sole specific purpose of supporting the test needles to be present, which leads to a structural complication of the interface and an increase in its cost.

Furthermore, the material supporting the needles by friction (sponge or rubber) by its nature absorbs atmospheric moisture and other impurities that reduce the insulation resistance value between the test needles.

Insertion of the needles into the interface becomes difficult because the supporting material must be perforated by the needle. The retaining force itself prevents the needle from sliding freely in the interface, reducing the force of contact between the needle and the printed circuit board.

In the case of retention by interference (Figure 2), the force necessary for insertion of the needles, together with the weakening of the needles at the reduction in diameter, makes it possible for them to be damaged during assembly or disassembly.

The object of the invention is to eliminate the drawbacks of the above described known solutions, providing a solution for retention of the test needle in the interface which does not require additional elements, which is simple and economical to make and is extremely reliable.

The object is achieved with the test needle according to the invention, which has the characteristics of the appended claim 1.

Advantageous embodiments of the invention are described in the dependent claims.

Basically, a small permanent deformation is made in an intermediate portion of the needle, ensuring support thereof on an intermediate plate of the interface, though allowing the needle to protrude from the interface by an amount which allows it to reach the printed circuit board.

Further characteristics of the invention will be made clearer by the detailed description that follows, referring to a purely exemplary and therefore non-limiting embodiment thereof, illustrated in the appended drawings, in which:
Figures 1 and 2 are part sections of the upper interface of a test machine, showing respective known solutions for retention of a test needle;
Figure 3 is a diagrammatic cross section of a test needle according to the invention inserted in an upper interface.

Figure 1 shows the known solution consisting in inserting the test needle 1 in a sheet of latex or rubber interposed between a pair of plates 3, 4. In this case retention takes place through friction between the needle 1 and the sheet 2.

Figure 2 shows another solution of the prior art, in which a groove 5 is made on the stem of the needle 1, said groove engaging in a hole 7 in a Mylar sheet 6, also interposed between a pair of plates 3, 4. In this case retention takes place through mechanical interference, the diameter of the hole 7 being smaller than that of the stem of the needle 1 but greater than that of the narrowing 5.

The solution according to the invention is now described, with reference to Figure 3, where 10 generically indicates the upper interface of a test machine, comprising a lower plate 20, which is positioned in the immediate vicinity of the upper side of printed circuit board 100 to be tested, and an upper plate 30, positioned distally to the circuit board 100, adjacent to a universal grid of the test machine, not shown. The two plates 20, 30 are kept assembled to each other by spacers 50, and at least one intermediate plate 40 is disposed between them, in a fixed position with respect to them.

In the figure a test needle 1 is shown with its point or head 60 in contact with a metallized hole 90 of the printed circuit board 100.

The point 60 for the test on the metallized holes 90, made of conductive material such as brass or copper alloys, has a diameter greater than that of the hole to be tested, and therefore generally much greater than that of the stem of the needle 1.

According to the invention, a small permanent deformation or bend 70 is made in an intermediate area between the two ends of the needle 1. The position of the deformation 70 is such as to ensure that the needle is supported on the intermediate plate 40 of the interface 10, but allowing the point 60 of the needle to protrude from the lower plate 20 of the interface by an amount (at least 2 mm) that allows the point 60 to reach the printed circuit board 100.

The size of the arrow "f" of the deformation 70 must be greater, for example 0.1 mm greater, than the diameter of the hole 41 through which the needle passes in the intermediate plate 40, whereas the length "l" of this deformation must indicatively be twice the thickness "s" of the plate 40 on which it rests or less.

During insertion of the needle into the interface 10, the inherent elasticity of the material of which the needle is made, normally music wire for spring, makes it possible, with a small axial force, to make the bend 70 in the stem pass in the hole 41 of the plate 40, from the bottom upwards. The needle's own weight is obviously not comparable to said axial force and, once the needle has been inserted in the interface, it remains supported on the inside thereof by the plate 40. The same axial force must be applied to extract the needle from the interface, for example by grasping the needle at the point 60 with tweezers.

The radius of the point or head 60 of the needle, always greater than the size of the arrow "f" of the deformation 70, ensures that two adjacent needles 1 cannot make contact with each other in the area of the deformations 70 of their respective stems. In fact, they must necessarily be installed with a distance between the axes greater than the diameter of the head 60.

The solution described above with reference to the upper interface of a test machine, can be transferred, with slight adaptations, to the lower interface. In this case, for example, the deformation 70 will be disposed above the intermediate plate 40 of the interface.

## Claims

1. A rigid needle for the electrical test on printed circuit boards (100) in particular for testing metallized holes (90) in the circuit board (100), inserted in an interface (10) of the test machine, comprising a plate (20) proximal to the printed circuit board (100), a distal plate (30) and at least one intermediate plate (40), all integral with each other by means of distance pieces (50), characterized in that said needle (1), in an intermediate area between its point or head (60) of contact with the metallized hole (90) and the other end, has a permanent deformation or bend (70), able to position itself on said intermediate plate (40) to ensure support of the needle (1), allowing said point (60) to protrude from said proximal plate (20).

2. A test needle according to claim 1, characterized in that the size of the arrow ( 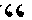 f 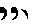 ) of said bend (70) of the needle (1) is about 0.1 mm larger than the diameter of the hole (41) through which the needle passes in said plate (40).

3. A test needle according to claim 1 or 2, characterized in that the length ("l") of said bend (70) is twice the thickness ("s") of said plate (40) on which it rests, or less.

4. A test needle according to any one of the preceding claims, characterized in that the size of the arrow ("f") of the bend (70) is smaller than the radius of the point or head (60) of the needle.

5. A test needle according to any one of the preceding claims, characterized in that in the position in which said bend (70) rests on the intermediate plate (40), the point or head (60) of the needle protrudes at least 2 mm from said proximal plate (20).

6. A test needle according to any one of the preceding claims, characterized in that said needle (1) is inserted in said hole (41) in the plate (40) with an axial force exceeding the needle's own weight.

7. An interface (10) of a machine for the electrical test on printed circuit boards (100), comprising a plate (20) proximal to said printed circuit board (100), a distal plate (30) and at least one intermediate plate (40), all integral with each other by means of spacers (50), as well as a plurality of rigid test needles (1), in particular for the test on metallized holes (90) of said printed circuit board (100), provided with a point or head (60) with a larger diameter than the stem of the needle, characterized in that said test needles (1) have a respective permanent deformation or bend (70) in an intermediate area that rests on said intermediate plate (40) to support the needle.

8. An interface according to claim 7, characterized in that the size of the arrow ("f") of said bend (70) is greater than the diameter of the hole (41) in the plate (40) in which the needle is inserted, and smaller than the radius of said point or head (60) of the needle.

9. An interface according to claim 7 or 8, characterized in that the length ("l") of said bend (70) is twice the thickness ("s") of said plate (40) or less.
